# EUROPEAN PATENT APPLICATION

(11) **EP 4 102 583 A1**
(43) Date of publication of application: **14.12.2022**
(21) Application number: 20917771.6
(22) Date of filing: 18.12.2020
(51) Int. Cl.: H01L 41/187, H01L 41/313, H01L 41/337

(54) **COMPOSITE SUBSTRATE AND METHOD FOR MANUFACTURING SAME**

(30) Priority: 03.02.2020 JP 2020016029
(71) Applicant: Shin-Etsu Chemical Co., Ltd., Tokyo 100-0005 (JP)
(72) Inventor: AKIYAMA, Shoji, Annaka-shi, Gunma 379-0195 (JP)
(74) Representative: Vossius & Partner Patentanwälte Rechtsanwälte mbB
(86) International application number: PCT/JP2020/047336
(87) International publication number: WO 2021/157218

(57) **Abstract**

A manufacturing method of a composite substrate capable of suppressing damage due to heat treatment after bonding, and a composite substrate manufactured by the method are provided. The manufacturing method of a composite substrate according to the present invention is a manufacturing method of a composite substrate in which a piezoelectric wafer, which is a lithium tantalate wafer or lithium niobate wafer, and a support wafer are bonded together. This manufacturing method is characterized by a step of bonding a piezoelectric wafer and a support wafer, and a step of performing heat treatment of the wafer bonded in the step of bonding, with the non-bonded surface of the piezoelectric wafer being a mirror surface.

## Description

### Technical Field

The present invention relates to a composite substrate used as a material for surface acoustic wave devices and the like and a manufacturing method thereof.

### Background Art

In recent years, in the market of mobile communications typified by smartphones, data traffic has rapidly increased. As the number of required bands is increased to address this problem, it is inevitable that the various components must be made smaller and have higher performance. Common piezoelectric materials such as lithium tantalate (LT) and lithium niobate (LN) are widely used as materials for surface acoustic wave (SAW) devices. However, while these materials have a large electromechanical coupling coefficient and the bandwidth of the devices can be broadened, there is a problem that the temperature stability of the materials is low, and so the adaptable frequency is shifted by the temperature change. This is because lithium tantalate or lithium niobate has a very high thermal expansion coefficient.

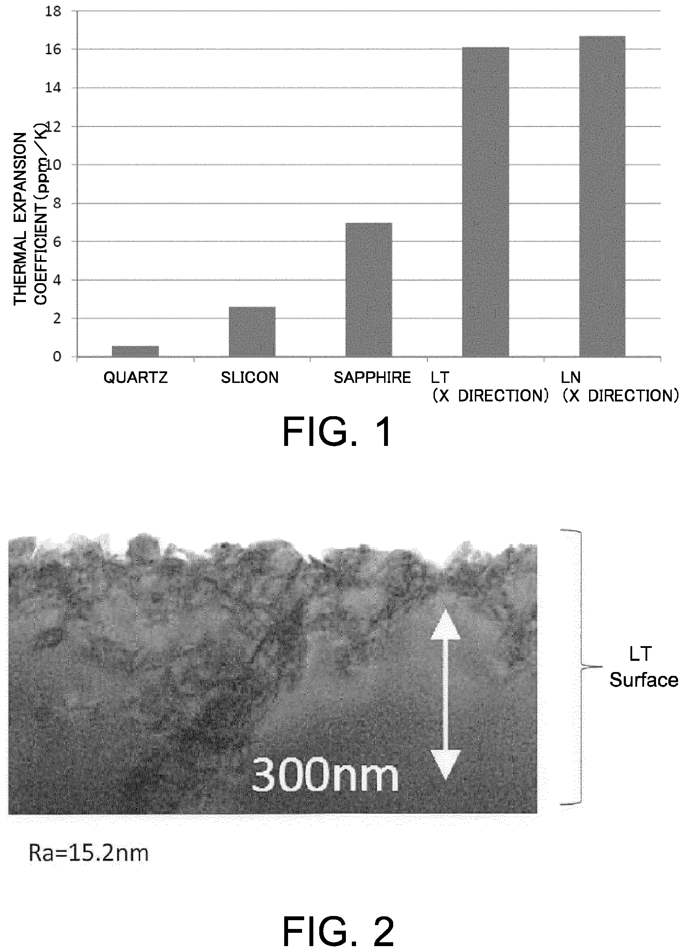

To reduce this problem, a method has been proposed in which lithium tantalate (LT) or lithium niobate (LN) is bonded to a material with a small expansion coefficient, and the LT or LN is thinned to several µm to several tens µm by grinding or other means to obtain a composite substrate (composite wafer) (Non-Patent Document 1). Another method is to implant ions such as hydrogen into LT or LN wafer in advance to facilitate delamination at the ion-implanted interface, then bonded to support wafer made of low thermal expansion coefficient material (sapphire, silicon, and the like) to increase bonding strength, and then peel at the ion-implanted interface, thereby thin LT or LN film on the low thermal expansion wafer is obtained. Composite wafer produced in this way can reduce the thermal expansion of LT and improve its temperature characteristics. For reference, the coefficients of thermal expansion of various materials are graphed in Fig. 1.

### Prior Art References

### Non-Patent Documents

Non-Patent Document 1: Temperature Compensation Technology for SAW-Duplexer Used in RF Front End of Smartphone, Dempa Shimbun High Technology, Nov. 8, 2012

### Summary of the Invention

### Problems to be solved by the Invention

However, the above method has problems in manufacturing. In general, after LT or LN wafers are bonded to wafers with a low thermal expansion coefficient, which serve as support wafers, some heat treatment is required to increase the bonding strength. In this case, the problem is that the difference in expansion coefficients between the two wafers causes cracks in the LT or LN wafers, resulting in damage to the entire bonded composite wafer.

In view of these problems, it is an object of the present invention to provide a manufacturing method of a composite substrate capable of suppressing damage due to heat treatment after bonding, and a composite substrate manufactured by the method.

### Means for solving the Problems

To solve the above problems, a manufacturing method of a composite substrate according to the embodiment of the present invention is a manufacturing method of a composite substrate in which a piezoelectric wafer, which is a lithium tantalate wafer or lithium niobate wafer, and a support wafer are bonded together. This manufacturing method is characterized by a step of bonding a piezoelectric wafer and a support wafer and a step of performing heat treatment of the wafer bonded in the step of bonding, with the non-bonded surface of the piezoelectric wafer being a mirror surface.

In the present invention, a step of mirroring the non-bonded surface of the piezoelectric wafer prior to the step of bonding may be further provided. Alternatively, a step of mirroring the non-bonded surface of the non-bonded surface of the piezoelectric wafer after the step of bonding may be further provided.

In the present invention, the roughness of the non-bonded surface of the piezoelectric wafer when the step of performing heat treatment is performed may be less than 12 nm in arithmetic mean roughness Ra.

The manufacturing method according to the present invention may further include a step of thinning the piezoelectric wafers after the step of performing heat treatment.

The manufacturing method according to the present invention may further include a step of implanting ions from the bonded surface of the piezoelectric wafers to a depth that becomes the delamination interface prior to the step of bonding. The ion species implanted in the step of implanting ions may be H⁺ or H₂⁺.

In the present invention, the step of thinning may be done by grinding and/or polishing. Alternatively, the step of thinning may be done by ion implantation peeling.

The manufacturing method according to the present invention may further include a step of forming an intervening layer on the bonded surface of the piezoelectric wafer prior to the step of bonding. The intervening layer may be any of SiO₂, SiON, SiN, or amorphous Si. The roughness of the surface of the intervening layer on the bonded surface of the piezoelectric wafer may be less than 12 nm in arithmetic mean roughness Ra.

The manufacturing method according to the present invention may further include a step of applying a surface activation treatment to the piezoelectric wafer and/or the support wafer prior to the bonding step. The surface activation treatment may include any of plasma activation, vacuum ion beam activation, activation by ozonated water treatment, or UV ozone treatment.

In the present invention, the support wafer may be selected from silicon, silicon with an oxide film, sapphire, glass, quartz, and alumina.

The composite substrate according to the present invention is characterized by being manufactured by any of the above manufacturing methods.

The composite substrate according to the present invention is a composite substrate in which a piezoelectric wafer, which is a lithium tantalate or lithium niobate wafer, and a support wafer are bonded together, wherein the non-bonded surface of the piezoelectric wafer is mirror-finished.

### Brief Description of the Drawings

Fig. 1 is a graph showing the coefficients of thermal expansion of various materials in contrast.
Fig. 2 shows a cross-sectional TEM image of an LT wafer surface finished by grinding.
Fig. 3 shows a cross-sectional TEM image of the near-surface of an LT wafer to which lapping is applied.
Fig. 4 shows the definition of the front and back surface of each wafer.

### Description of Embodiments

Hereinafter, embodiments of the present invention will be described in detail, but the present invention is not limited thereto. First, prior to the embodiments, the manufacturing method of composite substrates, which has been commonly practiced conventionally, is explained.

Usually, the back surface of piezoelectric wafers (LT or LN wafers) is usually rough and not mirror-finished. This is because wafers that need to construct fine patterns of several tens of nanometers, such as the most advanced silicon CMOS circuits, need to reduce surface unevenness to the utmost limit, and therefore a double side polished (DSP) wafer in which the back surface of the wafer is also mirror polished are used for this purpose, whereas SAW devices using LT and LN have patterns of only a few micrometers to sub-micrometer, so mirror-finishing the back surface only increases cost and provides few benefits.

If the back surface is mirror-finished, the manufacturing apparatus cannot recognize the LN or LN as a transparent body (the location of the wafer cannot be identified in the image obtained using a camera or other means). To prevent this and to make it easier for the manufacturing apparatus to recognize the wafer, there is a requirement to roughen the back surface to make it opaque (i.e., fogging), which is another reason why double side polished wafers are rarely used.

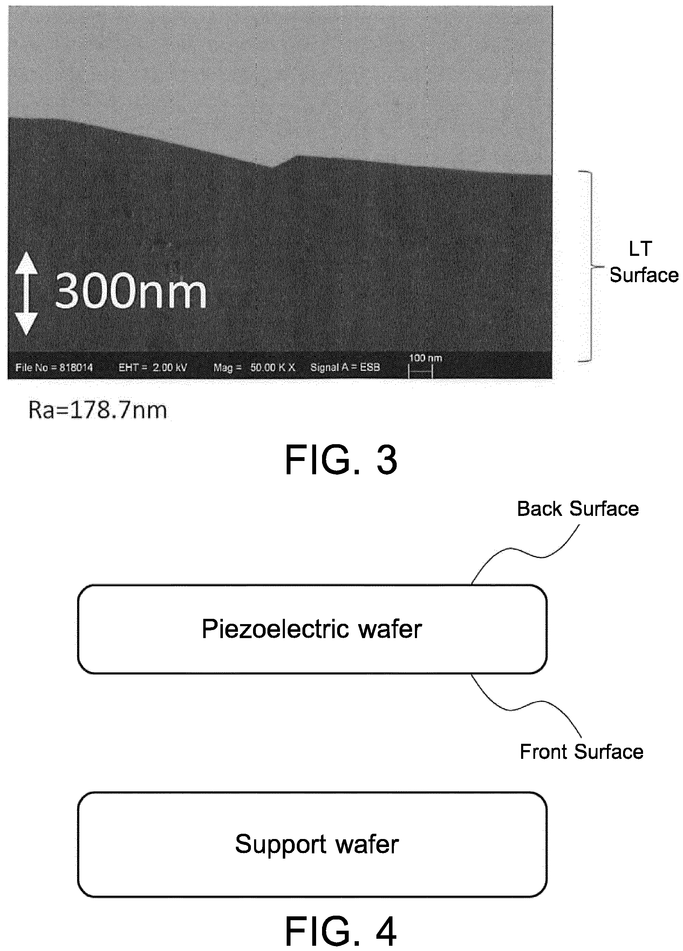

Therefore, piezoelectric wafers are generally used without being mirror-finished, with grinding, lapping, etching, sandblasting, or other treatments on the back surface. As an example, a cross-sectional TEM image of an LT wafer surface finished by grinding is shown in Fig. 2. Fig. 2 is a cross-sectional TEM image of LT after grinding with a #4000 grinding wheel (grain size of about 3 to 6 µm). It can be seen from Fig. 2 that there are numerous cracks on the grinding surface. These cracks are the starting point for damage to the wafers during heat treatment, resulting in a significant reduction in yield. Fig. 3 is a cross-sectional TEM image of the near-surface area after lapping with #2500 abrasive grains of silicon carbide. Unlike the case in Fig. 2, no cracks are seen, but the surface is uneven, and when stress is applied, stress is concentrated on the uneven areas, and the wafer is likely to be easily damaged.

In contrast, in the present embodiment, the heat treatment after the bonding is performed with the back surface (i.e., the non-bonded surface) of the piezoelectric wafer mirror-finished. This process greatly improves the tolerance to heat treatment after bonding. This is due to the fact that even if the substrate is deformed by heat treatment after bonding, the temperature at which breakage occurs can be increased because there are no cracks or unevenness that could serve as a starting point for cracking. The piezoelectric wafer may be made of a piezoelectric wafer with the back surface mirror-finished beforehand, or the back surface of the piezoelectric wafers may be mirror-finished after the bonding. Note that, in this embodiment, as shown in Fig. 4, the bonded surface is defined as the front surface, and the non-bonded surface is defined as the back surface.

### EXAMPLES

### (Example 1)

Silicon wafers of 100 mm in diameter and 0.55 mm in thickness were prepared, and a thermal oxide film (SiO₂) was grown at a temperature of 1000°C for about 480 nm. The lithium tantalate (LT) wafers used were 42° Y-cut wafers with a thickness of 0.35 mm. The surface roughness (of the bonded surface) of the LT wafers, which serve as the piezoelectric wafer, and the silicon wafers, which serve as the support wafer, were confirmed to be less than 0.3 nm in RMS. Three types of LT wafers were prepared. The arithmetic mean roughness Ra of the respective back surfaces (non-bonded surfaces) were 0.45 nm, 15.2 nm, and 178.7 nm (measured by AFM in a 10 µm × 10 µm area).

These wafers were surface-activated by plasma activation treatment, and bonding was performed. Then, the bonded wafers were subjected to heat treatment. In the heat treatment, the temperature was increased in steps of 10°C from 90°C. At each temperature, the temperature was maintained for 6 hours. The damage after each temperature is shown in Table 1. Table 1 shows that the less roughness on the back surface, the higher the temperature at which breakage occurs. Similar experiments were performed on lithium niobate (LN) wafers, with the same results.

**[Table 1]**

| | 90°C | 100°C | 110°C | 120°C | 130°C | 140°C | 150°C | 160°C |
|---|---|---|---|---|---|---|---|---|
| Ra: 178.7nm | ○ | ○ | × | | | | | |
| Ra: 15.2run | ○ | ○ | ○ | × | | | | |
| Ra: 0.45nm | ○ | ○ | ○ | ○ | ○ | ○ | ○ | × |

| | | | | | | | | |
|---|---|---|---|---|---|---|---|---|
| ○ = No Damage × = Damaged | | | | | | | | |

### (Example 2)

Silicon wafers of 100 mm in diameter and 0.55 mm in thickness were prepared, and a thermal oxide film (SiO₂) was grown at a temperature of 1000°C for about 480 nm. The lithium tantalate (LT) wafers used were 42° Y-cut wafers with a thickness of 0.35 mm. The surface roughness (of the bonded surface) of the LT wafers, which serve as the piezoelectric wafers, and the silicon wafers, which serve as the support wafers, were confirmed to be less than 0.3 nm in RMS. A plurality of LT wafers were prepared, and the arithmetic mean roughness Ra of the back surface (non-bonded surface) of each was varied from 0.27 nm (the lowest value achievable by polishing) to 23.36 nm.

These wafers were surface-activated by plasma activation treatment, and bonding was performed. Then, the bonded wafers were subjected to heat treatment at temperatures starting at 90°C and rising to a maximum of 160°C. The damage status of LT wafers according to the arithmetic mean roughness Ra of the back surface is shown in Table 2. Table 2 shows that if the roughness of the back surface is less than Ra = 12 nm, it is as tolerant as a mirror surface (Ra = 0.27 nm). Similar experiments were performed on lithium niobate (LN) wafers, with the same results.

**[Table 2]**

| | Ra (nm) | | | | | | | | |
|---|---|---|---|---|---|---|---|---|---|
| | 0. 27 | 0. 45 | 1. 01 | 3. 35 | 7. 98 | 12. 05 | 14,51 | 15. 20 | 23. 36 |
| Damage Status | ○ | ○ | ○ | ○ | ○ | ○ | Cracks | × | × |

| | | | | | | | | | |
|---|---|---|---|---|---|---|---|---|---|
| ○ = No Damage × = Damaged | | | | | | | | | |

### (Example 3)

Silicon wafers of 100 mm in diameter and 0.55 mm in thickness were prepared, and a thermal oxide film (SiO₂) was grown at a temperature of 1000°C for about 480 nm. The surface roughness of both the lithium tantalate (LT) wafers, which serve as the piezoelectric wafers, and the silicon wafers, which serve as the support wafers, were RMS 0.3 nm or less. The LT wafers were previously implanted with molecular hydrogen ions (H₂⁺) at an energy of 100 KeV with a dose amount of 8 × 10¹⁶/cm². The depth of implantation at this time, as viewed from the surface, is approximately 620 nm. This depth of implantation is the delamination interface at the time of peeling.

These wafers were surface-activated by plasma activation treatment before bonding. After bonding, the same heat treatment as in Example 1 was performed. The damage after each temperature is shown in Table 3 for each arithmetic mean roughness Ra on the back surface of LT wafers. Table 3 shows that even with ion-implanted LT wafers, the tendency was not different from that of Example 1, and the one with the mirror-finished back surface (Ra = 0.45 nm) could be heated up to the temperature where the wafer could be peeled off (130-140°C) without damage. Similar experiments were performed on lithium niobate (LN) wafers, with the same results . The same results were also obtained when LT or LN wafers were implanted with hydrogen ions ( H⁺ implanted to the same depth.

**[Table 3]**

| | 90°C | 100°C | 110°C | 120°C | 130°C | 140°C | 150°C | 160°C |
|---|---|---|---|---|---|---|---|---|
| Ra: 178.7nm | ○ | ○ | × | | | | | |
| Ra: 15.2nm | ○ | ○ | ○ | × | | | | |
| Ra: 0.45nm | ○ | ○ | ○ | ○ | ○ | Partially delaminated from ion-implanted interface | Partially delaminated from ion-implanted interface →Damaged | Partially delaminated from ion-implanted interface →Damaged |

| | | | | | | | | |
|---|---|---|---|---|---|---|---|---|
| ○ = No Damage × = Damaged | | | | | | | | |

### (Example 4)

In Examples 1-3, 300 nm of SiO2 was deposited as an intervening layer on the front surface (bonded surface) of LT or LN by PVD (physical vapor deposition) method and polished, followed by the same treatment as in Examples 1-3. The results were the same as in Examples 1-3. The results show that the presence or absence of the intervening layer does not affect the present invention. The results were the same when LN was used instead of LT.

### (Example 5)

In the experiments of Example 4, the intervening layer was changed to SiO₂ deposited by a CVD method, SiN, SiON, amorphous Si, and the like, but the results were the same as in Example 4. The results show that the type of the intervening layer does not affect the present invention. The results were the same when LN was used instead of LT.

### (Example 6)

Similar tests as Example 3 were attempted by changing the surface activation treatment during bonding in Example 3 to vacuum ion beam activation, activation by ozonated water treatment, or UV ozone treatment. The results were similar to Example 3. The results show that the bonding method does not affect the present invention.

### (Example 7)

The same experiments as in Examples 1-3 were performed. However, the bonded surface (front surface) side of the LT was roughened to 130 nm in arithmetic mean roughness Ra. The LT wafers were deposited with about 5 µm of SiO₂ by the CVD method, and the deposited SiO₂ was polished to about 2 µm and mirror-finished. The surface roughness of the SiO₂ surface was 0.25 nm in arithmetic mean roughness Ra. The remaining conditions were the same as in Examples 1-3, and the results were also the same as in Examples 1-3. The results show that the roughness on the front surface side (bonded surface side) of the LT does not affect the present invention if there is an appropriate intervening layer.

### (Example 8)

Silicon wafers of 100 mm in diameter and 0.55 mm in thickness were prepared, and a thermal oxide film (SiO₂) was grown at a temperature of 1000°C for about 480 nm. The lithium tantalate (LT) wafers used were 42° Y-cut wafers with a thickness of 0.35 mm. The surface roughness (of the bonded surface) of the LT wafers, which serve as the piezoelectric wafers, and the silicon wafers, which serve as the support wafers, were confirmed to be less than 0.3 nm in RMS. The Ra of the respective back surface (non-bonded surfaces) of the LT wafers was 178.7 nm (measured by AFM in a 10 µm × 10 µm area) .

These wafers were surface-activated by plasma activation treatment, and bonding was performed. Then, the bonded wafers were subjected to heat treatment. After heat treatment from 90°C to 100°C, the back surface of the rough LT was mirror-finished by polishing, and the temperature was raised again from 110°C. At this time, the breakage occurred for the first time at 160 °C. The results were found to be the same whether the backs of the LT wafers were mirror-finished before or after bonding.

### (Example 9)

In performing the same experiments as in Examples 1-3, silicon without oxide film, sapphire, alumina, glass, or quartz was used as the support wafer. The results were almost the same as in Examples 1-3, and it was found that the results did not greatly depend on the type of the support wafer. From these results, it can be inferred that the breakage originates from the back surface of the LT or LN wafer rather than from the support wafer.

According to the embodiments and examples described above, it can be seen that the manufacturing method for the present invention can produce a composite substrate that can suppress damage caused by heat treatment after bonding.

The above embodiments and examples are examples only, and any configuration that is substantially the same as the technical concept described in the claims of the present invention and that produces similar effects is included in the technical scope of the present invention.

## Claims

1. A manufacturing method of a composite substrate in which a piezoelectric wafer, which is a lithium tantalate wafer or lithium niobate wafer, and a support wafer are bonded together, comprising:
a step of bonding the piezoelectric wafer and the support wafer; and
a step of performing heat treatment of the wafer bonded in the step of bonding, with the non-bonded surface of the piezoelectric wafer being a mirror surface.

2. The manufacturing method as claimed in claim 1, further comprises a step of mirroring the non-bonded surface of the piezoelectric wafer prior to the step of bonding.

3. The manufacturing method as claimed in claim 1, further comprises a step of mirroring the non-bonded surface of the piezoelectric wafer after the step of bonding.

4. The manufacturing method as claimed in any one of claims 1 to 3, wherein
the roughness of the non-bonded surface of the piezoelectric wafer when the step of performing heat treatment is performed is less than 12 nm in arithmetic mean roughness Ra.

5. The manufacturing method as claimed in any one of claims 1 to 4, further comprises a step of thinning the piezoelectric wafers after the step of performing heat treatment.

6. The manufacturing method as claimed in claim 5, further comprises a step of implanting ions from the bonded surface of the piezoelectric wafers to a depth that becomes the delamination interface prior to the step of bonding.

7. The manufacturing method as claimed in claim 6, wherein the ion species implanted in the step of implanting ions is H⁺ or H₂⁺.

8. The manufacturing method as claimed in claim 5, wherein the step of thinning is done by grinding and/or polishing.

9. The manufacturing method as claimed in any one of claims 1 to 8, further comprises a step of forming an intervening layer on the bonded surface of the piezoelectric wafer prior to the step of bonding.

10. The manufacturing method as claimed in claim 9, wherein the type of the intervening layer includes any of SiO₂, SiON, SiN, or amorphous Si.

11. The manufacturing method as claimed in claim 10, wherein the roughness of the surface of the intervening layer on the bonded surface of the piezoelectric wafer is less than 12 nm in arithmetic mean roughness Ra.

12. The manufacturing method as claimed in any one of claims 1 to 11, further comprises a step of applying a surface activation treatment to the piezoelectric wafer and/or the support wafer prior to the bonding step.

13. The manufacturing method as claimed claim 12, wherein the surface activation treatment includes any of plasma activation, vacuum ion beam activation, activation by ozonated water treatment, or UV ozone treatment.

14. The manufacturing method as claimed in any one of claims 1 to 13, wherein the support wafer is selected from silicon, silicon with an oxide film, sapphire, glass, quartz, and alumina.

15. A composite substrate manufactured by the manufacturing method according to any one of claims 1 to 14.

16. A composite substrate in which a piezoelectric wafer, which is a lithium tantalate or lithium niobate wafer, and a support wafer are bonded together, wherein the non-bonded surface of the piezoelectric wafer is mirror-finished.
